# EUROPEAN PATENT APPLICATION

(11) **EP 4 618 416 A1**
(43) Date of publication of application: **17.09.2025**
(21) Application number: 23895973.8
(22) Date of filing: 28.06.2023
(51) Int. Cl.: H03K 3/013, H03K 3/03, H03K 3/0231, H03L 7/099

(54) **RING OSCILLATOR AND COMMUNICATION APPARATUS**

(30) Priority: 30.11.2022 CN 202211530272
(71) Applicant: Huawei Technologies Co., Ltd., Shenzhen, Guangdong 518129 (CN)
(72) Inventor: SHI, Kai, Shenzhen, Guangdong 518129 (CN)
(74) Representative: Grünecker Patent- und Rechtsanwälte PartG mbB
(86) International application number: PCT/CN2023/103168
(87) International publication number: WO 2024/113809

(57) **Abstract**

This application relates to the field of electronic technologies, and provides a ring oscillator and a communication apparatus, to reduce phase noise of the ring oscillator and improve performance of the ring oscillator. The ring oscillator includes at least three differential inverting amplifiers that are coupled in a ring. A first output end and a second output end of each differential inverting amplifier are respectively coupled to a first input end and a second input end of a next adjacent differential inverting amplifier. The at least three differential inverting amplifiers include a first differential inverting amplifier, a first input end of the first differential inverting amplifier is coupled to a first output end of the first differential inverting amplifier, and a second input end of the first differential inverting amplifier is coupled to a second output end of the first differential inverting amplifier. A polarity of the first input end and a polarity of the first output end are a first polarity, a polarity of the second input end and a polarity of the second output end are a second polarity, and the first polarity is opposite to the second polarity.

## Description

This application claims priority to Chinese Patent Application No. 202211530272.3, filed with the China National Intellectual Property Administration on November 30, 2022 and entitled "RING OSCILLATOR AND COMMUNICATION APPARATUS", which is incorporated herein by reference in its entirety.

### TECHNICAL FIELD

This application relates to the field of electronic technologies, and in particular, to a ring oscillator and a communication apparatus.

### BACKGROUND

An oscillator, as one of important units of an electronic system, has a wide range of applications. For example, the oscillator may be used in a phase locked loop of a wireless transceiver, and is configured to provide a stable local carrier signal for the wireless transceiver, to ensure communication performance of the transceiver. Generally, power consumption and phase noise of the oscillator are main parameters for measuring performance of the oscillator. Therefore, an oscillator with low power consumption and low phase noise has been studied for a long time.

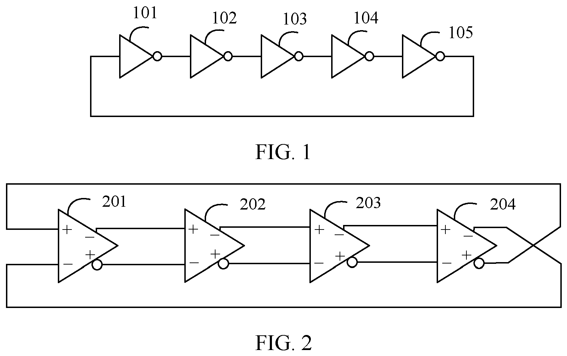

FIG. 1 is a diagram of a structure of a single-ended ring oscillator according to the conventional technology. The single-ended ring oscillator includes n single-ended inverting amplifiers that are coupled in a ring, where n is an odd number greater than or equal to 3. For example, the single-ended ring oscillator may include five single-ended inverting amplifiers that are coupled in a ring, and the five single-ended inverting amplifiers may be represented as 101 to 105, where an output end of each single-ended inverting amplifier is coupled to an input end of a next adjacent inverter. In an operating process, it is assumed that at a moment T0, an input end of the single-ended inverting amplifier 101 is at a high level, an output end of the single-ended inverting amplifier 101 (an input end of an inverter 102) changes to a low level after delay time ΔT (T = T0 + ΔT), an output end of the single-ended inverting amplifier 102 (an input end of an inverter 103) changes to a high level after delay time ΔT (T = T0 + 2ΔT), and the rest may be deduced by analogy. After 10ΔT, the input end of the single-ended inverting amplifier 101 changes to a high level, and the single-ended ring oscillator completes one cycle of oscillation. In actual application, a value of n is related to a speed, power consumption, phase noise, and the like of the oscillator. In FIG. 1, an example in which n is equal to 5 is used.

However, the single-ended ring oscillator is extremely sensitive to noise of both a power supply and the ground, and has poor anti-interference performance. In addition, in one oscillation cycle, time for converting noise of the single-ended inverting amplifier into phase noise is long. Consequently, more phase noise is generated, and performance of the single-ended ring oscillator is reduced.

### SUMMARY

This application relates to the field of electronic technologies, and provides a ring oscillator and a communication apparatus, to reduce phase noise of the ring oscillator and improve performance of the ring oscillator.

To achieve the foregoing objectives, this application uses the following technical solutions:

According to a first aspect, a ring oscillator is provided. The ring oscillator includes at least three differential inverting amplifiers that are coupled in a ring. Each differential inverting amplifier includes a first input end and a second input end that are differential, and a first output end and a second output end that are differential, and the first output end and the second output end of each differential inverting amplifier are respectively coupled to a first input end and a second input end of a next adjacent differential inverting amplifier. The at least three differential inverting amplifiers include a first differential inverting amplifier, a first input end of the first differential inverting amplifier is coupled to a first output end of the first differential inverting amplifier, and a second input end of the first differential inverting amplifier is coupled to a second output end of the first differential inverting amplifier. A polarity of the first input end and a polarity of the first output end are a first polarity, a polarity of the second input end and a polarity of the second output end are a second polarity, and the first polarity is opposite to the second polarity.

In the foregoing technical solution, each differential inverting amplifier includes the first input end and the second input end that are differential, the first output end and the second output end of each differential inverting amplifier are respectively coupled to the first input end and the second input end of the next adjacent differential inverting amplifier, the at least three differential inverting amplifiers include the first differential inverting amplifier, the first input end of the first differential inverting amplifier is coupled to the first output end, the second input end of the first differential inverting amplifier is coupled to the second output end, the polarity of the first input end and the polarity of the first output end are the first polarity, the polarity of the second input end and the polarity of the second output end are the same and are the second polarity, and the first polarity is opposite to the second polarity. In this way, when there is external noise interference, the noise interference is coupled to both the first input end and the second input end that are differential, and because the polarities of the first input end and the second input end are opposite, the external noise interference can be completely offset, that is, anti-interference performance of the ring oscillator is improved according to a differential principle. In addition, the polarity of the first input end is the same as the polarity of the first output end, and the polarity of the second input end is the same as the polarity of the second output end, that is, an input end and an output end that are of the first differential inverting amplifier and that have a same polarity are coupled, that is, the first differential inverting amplifier is coupled from the head to the tail, so that a conversion rate and symmetry of a differential oscillation waveform of the ring oscillator are improved, and a mean square value of an impulse-sensitive function is reduced, thereby reducing phase noise.

In a possible implementation of the first aspect, the at least three differential inverting amplifiers further include a second differential inverting amplifier and a third differential inverting amplifier, and the first differential inverting amplifier is coupled between the second differential inverting amplifier and the third differential inverting amplifier. In the foregoing possible implementation, the first differential inverting amplifier is coupled between the second differential inverting amplifier and the third differential inverting amplifier, that is, an input end and an output end that are of the first differential inverting amplifier located in the middle of the at least three differential inverting amplifiers and that have a same polarity are coupled to each other. This improves a conversion rate and symmetry of a differential oscillation waveform of the ring oscillator, and reduces a mean square value of an impulse-sensitive function, thereby reducing phase noise.

In a possible implementation of the first aspect, the ring oscillator further includes a first switch and a second switch, the first switch is coupled between the first input end of the first differential inverting amplifier and the first output end of the first differential inverting amplifier, and the second switch is coupled between the second input end of the first differential inverting amplifier and the second output end of the first differential inverting amplifier. In the foregoing possible implementation, the ring oscillator is controlled to separately operate in a low phase noise mode or an anti-interference mode by switching the first switch and the second switch, for example, simultaneously turning on or off the first switch and the second switch, so that the ring oscillator adapts to more operating modes, thereby improving utilization of the ring oscillator.

In a possible implementation of the first aspect, the ring oscillator is controlled to separately operate in a low phase noise mode or an anti-interference mode by switching the first switch and the second switch, for example, simultaneously turning on or off the first switch and the second switch. In the foregoing possible implementation, the ring oscillator is controlled to separately operate in the low phase noise mode or the anti-interference mode by switching the first switch and the second switch, so that the ring oscillator adapts to more operating modes, thereby improving utilization of the ring oscillator.

In a possible implementation of the first aspect, the at least three differential inverting amplifiers further include at least one fourth differential inverting amplifier, the at least one fourth differential inverting amplifier is coupled between the second differential inverting amplifier and the third differential inverting amplifier, a first input end of the at least one fourth differential inverting amplifier is coupled to a first output end of the at least one fourth differential inverting amplifier, a second input end of the at least one fourth differential inverting amplifier is coupled to a second output end of the at least one fourth differential inverting amplifier, a polarity of the first input end of the at least one fourth differential inverting amplifier and a polarity of the first output end of the at least one fourth differential inverting amplifier are the first polarity, and a polarity of the second input end of the at least one fourth differential inverting amplifier and a polarity of the second output end of the at least one fourth differential inverting amplifier are the second polarity. In the foregoing possible implementation, the at least one fourth differential inverting amplifier is added between the second differential inverting amplifier and the third differential inverting amplifier, so that a tuning range of the ring oscillator can be increased, and application scenarios of the ring oscillator can be further increased, thereby improving utilization of the ring oscillator.

In a possible implementation of the first aspect, the ring oscillator further includes a third switch and a fourth switch, the third switch is coupled between the first input end of the at least one fourth differential inverting amplifier and the first output end of the at least one fourth differential inverting amplifier, and the fourth switch is coupled between the second input end of the at least one fourth differential inverting amplifier and the second output end of the at least one fourth differential inverting amplifier. In the foregoing possible implementation, the ring oscillator can be controlled to separately operate in the low phase noise mode or the anti-interference mode by selectively switching the first switch and the second switch, and the third switch and the fourth switch. This improves utilization and operability of the ring oscillator.

In a possible implementation of the first aspect, at a first moment, the first switch and the second switch are turned off, and the third switch and the fourth switch are switched. For example, the third switch and the fourth switch may be simultaneously turned on or off, to control the ring oscillator to separately operate in the low phase noise mode or the anti-interference mode. Alternatively, at the first moment, the third switch and the fourth switch are turned off, and the first switch and the second switch are switched. For example, the first switch and the second switch may be simultaneously turned on or off, to control the ring oscillator to separately operate in the low phase noise mode or the anti-interference mode. In the foregoing possible implementation, the ring oscillator can be controlled to separately operate in the low phase noise mode or the anti-interference mode by selectively switching the first switch and the second switch, and the third switch and the fourth switch. This improves utilization and operability of the ring oscillator.

In a possible implementation of the first aspect, only one differential inverting amplifier in the at least three differential inverting amplifiers is reversely coupled to an adjacent differential inverting amplifier, and all other differential inverting amplifiers other than the differential inverting amplifier in the at least three differential inverting amplifiers are in-phase coupled to adjacent differential inverting amplifiers. In the foregoing possible implementation, normal running of the ring oscillator is ensured.

In a possible implementation of the first aspect, only one differential inverting amplifier in the at least three differential inverting amplifiers is in-phase coupled to an adjacent differential inverting amplifier, and all other differential inverting amplifiers other than the differential inverting amplifier in the at least three differential inverting amplifiers are reversely coupled to adjacent differential inverting amplifiers. In the foregoing possible implementation, normal running of the ring oscillator is ensured.

According to a second aspect, a phase locked loop circuit is provided. The phase locked loop circuit includes a phase detector, a filter, and a ring oscillator. The ring oscillator is the ring oscillator provided in the first aspect or any possible implementation of the first aspect, the phase detector is configured to: obtain a phase difference signal, and convert the phase difference signal into a voltage signal, the filter is configured to filter the voltage signal, and the ring oscillator is configured to output a local carrier signal based on the filtered voltage signal.

According to a third aspect, a communication apparatus is provided. The communication apparatus includes a phase locked loop circuit, and the phase locked loop circuit includes the ring oscillator provided in the first aspect or any possible implementation of the first aspect.

In a possible implementation of the third aspect, the communication apparatus further includes a radio frequency transceiver, the phase locked loop circuit is integrated into the radio frequency transceiver, and the phase locked loop circuit is configured to provide a local carrier signal for the radio frequency transceiver.

It may be understood that both the foregoing phase locked loop circuit and the communication apparatus include all content of the ring oscillator provided above. Therefore, for beneficial effects that can be achieved by the foregoing phase locked loop circuit and the communication apparatus, refer to beneficial effects in the ring oscillator provided above. Details are not described herein again.

### BRIEF DESCRIPTION OF DRAWINGS

FIG. 1 is a diagram of a structure of a single-ended ring oscillator according to the conventional technology;
FIG. 2 is a diagram of a structure of a differential ring oscillator;
FIG. 3 is a diagram of a structure of a communication apparatus according to an embodiment of this application;
FIG. 4 is a diagram of a structure of a phase locked loop circuit according to an embodiment of this application;
FIG. 5 is a diagram of a structure of a ring oscillator according to an embodiment of this application;
FIG. 6 is a diagram of a structure of another ring oscillator according to an embodiment of this application;
FIG. 7 is a diagram of circuit simulation according to an embodiment of this application;
FIG. 8 is a diagram of phase noise simulation according to an embodiment of this application;
FIG. 9 is a diagram of a structure of a ring oscillator according to an embodiment of this application;
FIG. 10 is a diagram of a structure of another ring oscillator according to an embodiment of this application;
FIG. 11 is a diagram of a structure of still another ring oscillator according to an embodiment of this application; and
FIG. 12 is a diagram of a structure of still another ring oscillator according to an embodiment of this application.

### DESCRIPTION OF EMBODIMENTS

In this application, "at least one" means one or more, and "a plurality of" means two or more. In addition, terms such as "first" and "second" are used in embodiments of this application to distinguish between same items or similar items that provide basically same functions and purposes. For example, a first threshold and a second threshold are merely used to distinguish between different thresholds, and a sequence thereof is not limited. A person skilled in the art may understand that the terms such as "first" and "second" do not limit a quantity and an execution sequence.

It should be noted that, in this application, the word such as "example" or "for example" represents giving an example, an illustration, or a description. Any embodiment or design scheme described as an "example" or "for example" in this application should not be explained as being more preferred or having more advantages than another embodiment or design scheme. To be precise, use of the word like "example" or "for example" is intended to present a relative concept in a specific manner.

Before embodiments of this application are described, related knowledge of an oscillator is first described.

The oscillator, as one of important units of an electronic system, has a wide range of applications. For example, the oscillator may be used in a phase locked loop of a wireless transceiver, and is configured to provide a stable local carrier signal for the wireless transceiver, to ensure communication performance of the transceiver. Generally, power consumption and phase noise of the oscillator are main parameters for measuring performance of the oscillator. Therefore, an oscillator with low power consumption and low phase noise has been studied for a long time. A ring oscillator may be implemented by using a complementary metal-oxide-semiconductor (complementary metal-oxide-semiconductor, CMOS) process, and does not require elements such as an inductor and a capacitor. Because of a simple structure, low costs, a small area, and a wide tuning range, the ring oscillator is widely used in communication apparatuses.

FIG. 1 shows a diagram of a structure of a conventional single-ended ring oscillator. However, the single-ended ring oscillator shown in FIG. 1 is extremely sensitive to noise of both a power supply and the ground, and has poor anti-interference performance. In addition, in one oscillation cycle, time for converting noise of the single-ended inverting amplifier into phase noise is long. Consequently, more phase noise is generated, and performance of the single-ended ring oscillator is reduced.

Based on the single-ended ring oscillator shown in FIG. 1, a differential ring oscillator is provided. FIG. 2 is a diagram of a structure of a conventional differential ring oscillator. The differential ring oscillator includes m differential inverting amplifiers that are coupled in a ring, where m is an integer greater than or equal to 2. A differential output end (including two output ends with opposite polarities) of each differential inverting amplifier is coupled to a differential input end (including two input ends with opposite polarities) of a next adjacent differential inverting amplifier. For example, the differential ring oscillator may include four differential inverting amplifiers that are coupled in a ring, and the four differential inverting amplifiers may be represented as 201 to 204. The differential inverting amplifier 201 and the differential inverting amplifier 204 are in-phase coupled (that is, a positive electrode of a differential input end of the differential inverting amplifier 201 is coupled to a positive electrode of a differential output end of the differential inverting amplifier 204, and a negative electrode of a differential input end of the differential inverting amplifier 201 is coupled to a negative electrode of a differential output end of the differential inverting amplifier 204), and all other differential inverting amplifiers other than the differential inverting amplifier 201 and the differential inverting amplifier 204 are reversely coupled (for example, a negative electrode of a differential output end of the differential inverting amplifier 201 is coupled to a positive electrode of a differential input end of a differential inverting amplifier 203, and a positive electrode of a differential output end of the differential inverting amplifier 201 is coupled to a negative electrode of a differential input end of the differential inverting amplifier 203). In FIG. 2, an example in which m is equal to 4 is used. A specific operating process of the differential ring oscillator is similar to an operating process of the single-ended ring oscillator shown in FIG. 1. Details are not described herein again. The differential ring oscillator improves anti-interference performance of the differential ring oscillator according to a differential principle. For example, when there is external noise interference, the noise interference is coupled to differential input ends, and because polarities of two input ends included in the differential input ends are opposite, the external noise interference can be completely offset, that is, the anti-interference performance of the ring oscillator is improved by using the differential principle. However, in one oscillation cycle, time for converting noise of the differential inverting amplifier into phase noise is still long. Consequently, more phase noise is generated, and the performance of the differential ring oscillator is reduced.

In view of this, embodiments of this application provide a ring oscillator and a communication apparatus. The following first describes a structure of the communication apparatus.

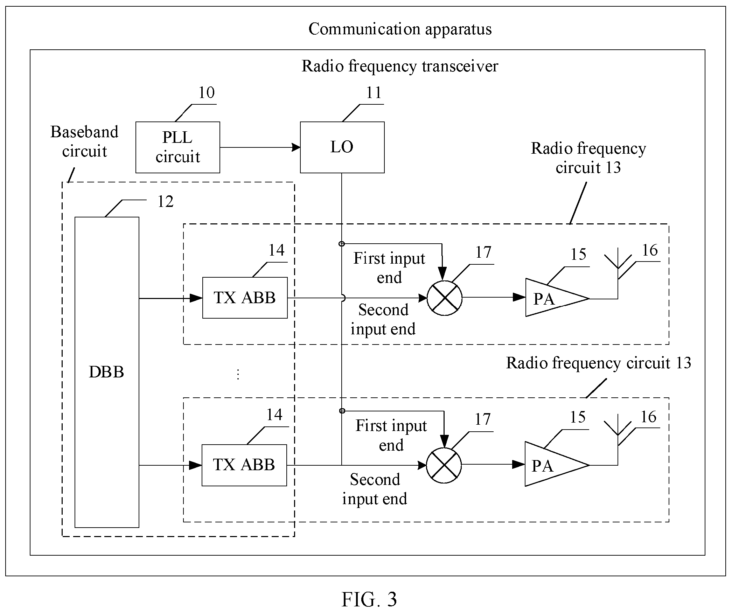

FIG. 3 is a diagram of a structure of a communication apparatus according to an embodiment of this application. The communication apparatus may include a radio frequency transceiver 01 and a plurality of radio frequency circuits 02, and the radio frequency transceiver 01 and the plurality of radio frequency circuits 02 share some components. The radio frequency transceiver 01 may include a phase locked loop (phase locked loop, PLL) circuit 10, a local oscillator (local oscillator generator, LO) 11, a digital baseband (digital baseband, DBB) circuit 12, a transmit analog baseband (transmit analog baseband, TX ABB) circuit 13, and a frequency mixer 14. Optionally, the communication apparatus may further include a power amplifier (power amplifier, PA) 15 and an antenna 16. Each radio frequency circuit 02 may include the TX ABB circuit 13, the frequency mixer 14, the PA 15, and the antenna 16. The PLL circuit 10 may include the ring oscillator provided in embodiments of this application. In a possible design, the DBB circuit 12 and the TX ABB circuit 13 are collectively referred to as a baseband circuit.

First, connection relationships between the foregoing components are described.

An output end of the PLL circuit 10 is connected to an input end of the LO 11. For each radio frequency circuit 02, an output end of the LO 11 is connected to a first input end of the frequency mixer 14.

On a transmit link of each radio frequency circuit 02, the DBB circuit 12 is connected to an input end of the TX ABB circuit 13, an output end of the TX ABB circuit 13 is connected to a second input end of the frequency mixer 14, an output end of the frequency mixer 14 is connected to an input end of the PA 15, and an output end of the PA 15 is connected to the antenna 16.

The following describes functions of the foregoing components.

The PLL circuit 10 is configured to output, to the LO 11, a first oscillation signal of a fixed clock frequency of each channel. The first oscillation signal may also be referred to as a local carrier signal.

The LO 11 is configured to: process the first oscillation signal, and output, to the frequency mixer 14, transmit oscillation signals of a plurality of local oscillation frequencies.

The DBB circuit 12 is configured to send a digital signal to the transmit link of the radio frequency circuit 13.

The TX ABB circuit 13 is configured to perform filtering and amplification processing on the digital signal from the DBB circuit 12.

The frequency mixer 14 is configured to: mix the transmit oscillation signal and a signal output by the TX ABB circuit 13, and output a mixed signal to the PA 15.

The PA 15 is configured to amplify the signal obtained through frequency mixing.

The antenna 16 is configured to transmit the signal amplified by the PA 15.

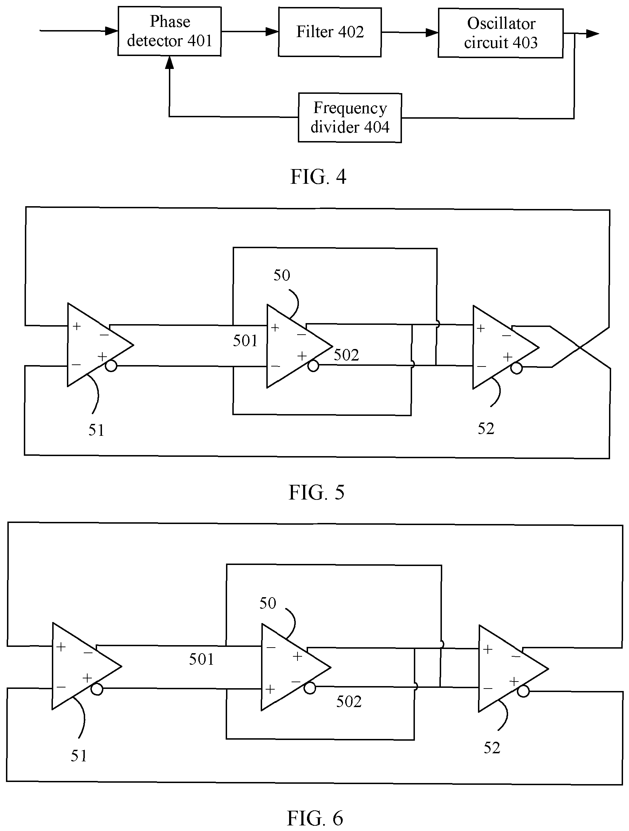

The following describes in detail a specific structure of a phase locked loop based on FIG. 4. FIG. 4 is a diagram of a structure of a phase locked loop circuit. The phase locked loop circuit may be the phase locked loop circuit shown in FIG. 3. The phase locked loop circuit includes a phase detector 401, a filter 402, a ring oscillator 403, and a frequency divider 404. The phase detector 401 is configured to: compare a reference signal with a local carrier signal fed back by the frequency divider 404 to obtain a phase difference signal, and convert the phase difference signal into a voltage signal for outputting, where the reference signal may be a signal provided by a reference frequency source. The filter 402 filters the voltage signal. The ring oscillator 403 is configured to output a local carrier signal based on the filtered voltage signal, where the local carrier signal may be fed back to the phase detector 401 through the frequency divider 404, to form a closed loop feedback circuit.

The following describes a specific structure of the ring oscillator based on FIG. 5. FIG. 5 is a diagram of a structure of a ring oscillator according to an embodiment of this application. The ring oscillator may be the ring oscillator provided in FIG. 3 and FIG. 4. The ring oscillator may include at least three differential inverting amplifiers that are coupled in a ring. Each differential inverting amplifier includes a first input end and a second input end that are differential, and a first output end and a second output end that are differential, and the first output end and the second output end of each differential inverting amplifier are respectively coupled to a first input end and a second input end of a next adjacent differential inverting amplifier. The at least three differential inverting amplifiers include a first differential inverting amplifier 50, a first input end 501 of the first differential inverting amplifier 50 is coupled to a first output end 502 of the first differential inverting amplifier 50, and a second input end 503 of the first differential inverting amplifier 50 is coupled to a second output end 504 of the first differential inverting amplifier 50. A polarity of the first input end 501 and a polarity of the first output end 502 are a first polarity, a polarity of the second input end 503 and a polarity of the second output end 504 are a second polarity, and the first polarity is opposite to the second polarity.

The differential inverting amplifier may also be usually referred to as a differential amplifier, a differential amplification circuit, or the like. For example, it is assumed that differential signals input to the differential inverting amplifier are Vᵢₙ₊ and Vᵢₙ₋. In this case, differential signals Vₒ₊ and Vₒ₋ output by the differential inverting amplifier may be represented as follows: Vₒ₊ = Aᵥ (Vᵢₙ₊ - Vᵢₙ₋), and Vₒ₋ = -Aᵥ (Vᵢₙ₊ - Vᵢₙ₋), where Aᵥ indicates an amplification gain. It can be learned that when the gain Aᵥ of the differential inverting amplifier is equal to 1, the differential inverting amplifier may be considered as an inverter without an amplification function. In this case, the differential inverting amplifier may also be referred to as a differential inverter or an inverter.

In addition, the at least three differential inverting amplifiers may include three differential inverting amplifiers, or may include more than three differential inverting amplifiers. For example, when the at least three differential inverting amplifiers include more than three differential inverting amplifiers, the at least three differential inverting amplifiers may include five differential inverting amplifiers, 10 differential inverting amplifiers, or more differential inverting amplifiers. The differential inverting amplifier may also be referred to as an inverting delay unit or an inverting amplifier. In FIG. 5, an example in which the at least three differential inverting amplifiers include three differential inverting amplifiers is used for description.

In addition, each differential inverting amplifier includes the first input end and the second input end that are differential, that is, the polarity of the first input end is opposite to the polarity of the second input end. For example, when the first input end is a positive electrode, the second input end is a negative electrode; or when the first input end is a negative electrode, the second input end is a positive electrode. Each differential inverting amplifier includes the first output end and the second output end that are differential, that is, the polarity of the first output end is opposite to the polarity of the second output end. For example, when the first output end is a positive electrode, the second output end is a negative electrode; or when the first output end is a negative electrode, the second output end is a positive electrode.

Moreover, the first polarity may be positive or negative, and the first polarity is opposite to the second polarity. For example, when the first polarity is positive, the second polarity is negative; or when the first polarity is negative, the second polarity is positive. For example, in a first possible implementation, the first polarity is positive, and the second polarity is negative, that is, the first input end 501 and the first output end 502 are positive electrodes, and the second input end 503 and the second output end 504 are negative electrodes. In a second possible implementation, the first polarity is negative, and the second polarity is positive, that is, the first input end 501 and the first output end 502 are negative electrodes, and the second input end 503 and the second output end 504 are positive electrodes. In FIG. 5, an example in which the first polarity is positive and the second polarity is negative is used.

It should be noted that an input end (including the first input end and the second input end that are differential) and an output end (including the first output end and the second output end that are differential) of the differential inverting amplifier are determined as positive or negative electrodes from a perspective of an electric potential. From a perspective of a phase, the input end and the output end are in-phase ends or inverting ends. The in-phase ends indicate that polarities of two ends (including any two of the first input end and the second input end that are differential, and the first output end and the second output end that are differential) are the same, and it may also be understood that signals corresponding to the two ends have a same phase, that is, the phase is 0 degrees or 180 degrees. The inverting ends indicate that polarities of the two ends are opposite, and it may also be understood that signals corresponding to the two ends have opposite phases, that is, one phase is 0 degrees, the other phase is 180 degrees, one of a positive electrode and a negative electrode indicates 0, and the other represents 180 degrees. For example, the positive electrode may be represented as 0, and the negative electrode may be represented as 180 degrees. Therefore, the positive electrode and the negative electrode are in opposite phases. For example, the first input end 501 and the first output end 502, and the second input end 503 and the second output end 504 shown in FIG. 5 are in-phase ends, and the first input end 501 and the second input end 503, and the first output end 502 and the second output end 504 are inverting ends.

In addition, the first output end and the second output end of each differential inverting amplifier in the at least three inverters are respectively coupled to a first input end and a second input end of a next adjacent differential inverting amplifier. For example, when the at least three inverters include three differential inverting amplifiers, the at least three differential inverting amplifiers may further include a second differential inverting amplifier 51 and a third differential inverting amplifier 52. The first differential inverting amplifier 50 is coupled between the second differential inverting amplifier 51 and the third differential inverting amplifier 52, a first output end and a second output end of the second differential inverting amplifier 51 are respectively coupled to the first input end and the second input end of the first differential inverting amplifier 50, the first output end and the second output end of the first differential inverting amplifier 50 are coupled to a first input end and a second input end of the third differential inverting amplifier 52, and a first output end and a second output end of the third differential inverting amplifier 52 are coupled to a first input end and a second input end of the second differential inverting amplifier 51.

In a possible embodiment, if only one differential inverting amplifier in the at least three differential inverting amplifiers is in-phase coupled to an adjacent differential inverting amplifier, all other differential inverting amplifiers other than the differential inverting amplifier in the at least three differential inverting amplifiers are reversely coupled to adjacent differential inverting amplifiers. For example, as shown in FIG. 5, the third differential inverting amplifier 52 and the second differential inverting amplifier 51 are in-phase coupled, that is, the first output end (positive electrode) of the third differential inverting amplifier 52 is coupled to the first input end (positive electrode) of the second differential inverting amplifier 51, and the second output end (negative electrode) of the third differential inverting amplifier 52 is coupled to the second input end (negative electrode) of the second differential inverting amplifier 51. The second differential inverting amplifier 51 is reversely coupled to the first differential inverting amplifier 50, and the first differential inverting amplifier 50 is also reversely coupled to the third differential inverting amplifier 52, that is, the first output end (negative electrode) of the second differential inverting amplifier 51 is coupled to the first input end 501 (positive electrode) of the first differential inverting amplifier 50, the second output end (positive electrode) of the second differential inverting amplifier 51 is coupled to the second input end 503 (negative electrode) of the first differential inverting amplifier 50, the second output end 504 (negative electrode) of the first differential inverting amplifier 50 is coupled to the first input end (positive electrode) of the third differential inverting amplifier 52, and the first output end 502 (positive electrode) of the first differential inverting amplifier 50 is coupled to the second input end (negative electrode) of the third differential inverting amplifier 52. In FIG. 5, an example in which the third differential inverting amplifier 52 is in-phase coupled to the second differential inverting amplifier 51 is used.

In another possible embodiment, if only one differential inverting amplifier in the at least three differential inverting amplifiers is reversely coupled to an adjacent differential inverting amplifier, all other differential inverting amplifiers other than the differential inverting amplifier in the at least three differential inverting amplifiers are in-phase coupled to adjacent differential inverting amplifiers. For example, FIG. 6 is a diagram of a structure of another ring oscillator according to an embodiment of this application. The ring oscillator may include a first differential inverting amplifier 50, a second differential inverting amplifier 51, and a third differential inverting amplifier 52 that are coupled in a ring. The third differential inverting amplifier 52 is reversely coupled to the second differential inverting amplifier 51, that is, a first output end (positive electrode) of the third differential inverting amplifier 52 is coupled to a second input end (negative electrode) of the second differential inverting amplifier 51, and a second output end (negative electrode) of the third differential inverting amplifier 52 is coupled to a first input end (positive electrode) of the second differential inverting amplifier 51. The second differential inverting amplifier 51 is in-phase coupled to the first differential inverting amplifier 50, and the first differential inverting amplifier 50 is also in-phase coupled to the third differential inverting amplifier 52, that is, a first output end (negative electrode) of the second differential inverting amplifier 51 is coupled to a first input end 501 (negative electrode) of the first differential inverting amplifier 50, a second output end (positive electrode) of the second differential inverting amplifier 51 is coupled to a second input end 503 (positive electrode) of the first differential inverting amplifier 50, a second output end 504 (positive electrode) of the first differential inverting amplifier 50 is coupled to a first input end (positive electrode) of the third differential inverting amplifier 52, and a first output end 502 (negative electrode) of the first differential inverting amplifier 50 is coupled to a second input end (negative electrode) of the third differential inverting amplifier 52. In FIG. 6, an example in which the third differential inverting amplifier 52 is reversely coupled to the second differential inverting amplifier 51, a first polarity is negative electrode, and a second polarity is positive is used.

In embodiments of this application, for each differential inverting amplifier, because a signal at the first input end and a signal at the second input end have equal magnitudes and opposite polarities, the signal at the first input end and the signal at the second input end may be referred to as differential signals. In actual application, a difference between the signal at the first input end and the signal at the second input end is used as an input signal, so that interference caused by external common mode noise to the input signal can be completely offset, thereby improving anti-interference performance of the ring oscillator.

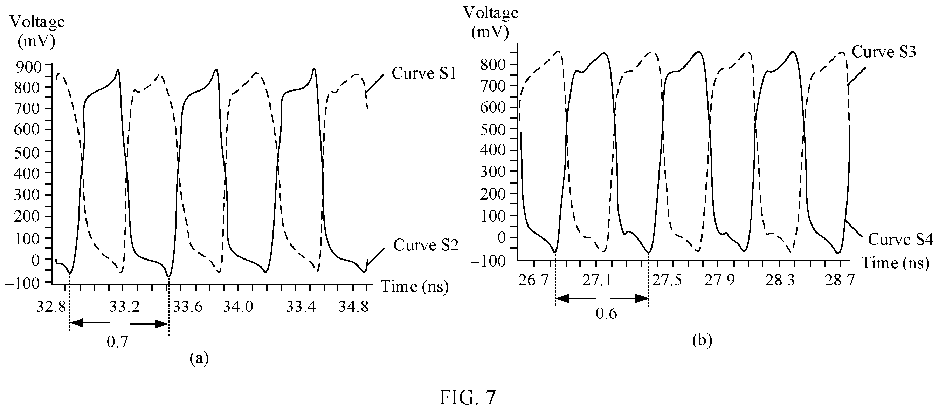

FIG. 7 is a diagram of circuit simulation according to an embodiment of this application. (a) in FIG. 7 is a diagram of a differential oscillation waveform of the differential oscillator shown in FIG. 2, and (b) in FIG. 7 is a diagram of a differential oscillation waveform of the ring oscillator shown in FIG. 5. A horizontal coordinate indicates time (nanosecond/ns), and a vertical coordinate indicates a voltage (millivolt/mV). As shown in (a) in FIG. 7, a curve S1 and a curve S2 are differential oscillation waveforms of the differential oscillator in one time period, and a waveform conversion rate is approximately 0.7 ns in one oscillation cycle. As shown in (b) in FIG. 7, a curve S3 and a curve S4 are differential oscillation waveforms of the ring oscillator in one time period, and a waveform conversion rate is approximately 0.6 ns in one oscillation cycle. It can be learned from FIG. 7 that, compared with the differential oscillator shown in FIG. 2, the ring oscillator shown in FIG. 5 has a higher conversion rate of a differential oscillation waveform and better symmetry of the differential oscillation waveform.

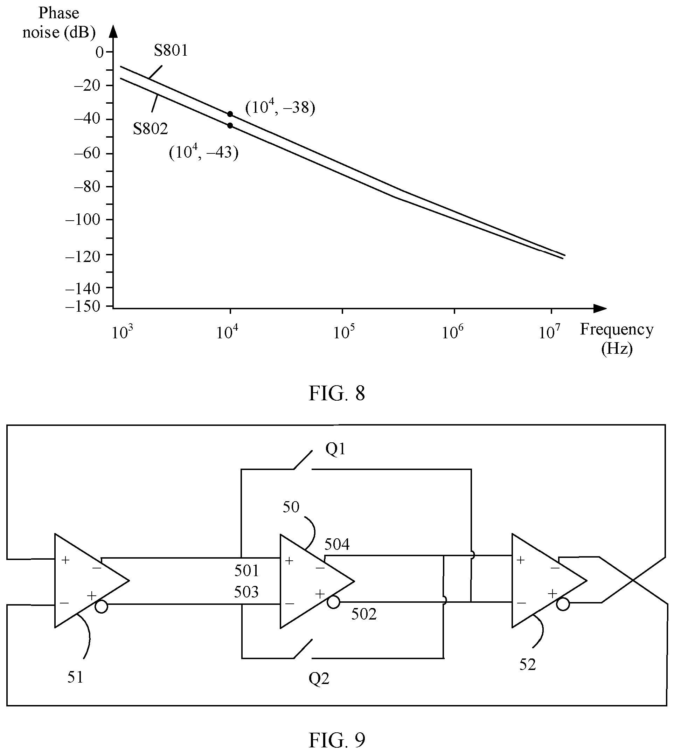

FIG. 8 is a diagram of phase noise simulation according to an embodiment of this application. A horizontal coordinate indicates a frequency (hertz/Hz), and a vertical coordinate indicates phase noise (decibel/dB). S801 is a change trend of phase noise of the differential oscillator shown in FIG. 2 at different frequencies, and S802 is a change trend of phase noise of the ring oscillator shown in FIG. 5 at different frequencies. At a frequency of 10⁴ Hz, phase noise of the differential oscillator shown in FIG. 2 is -38 decibels, and phase noise of the ring oscillator shown in FIG. 5 is -43 decibels. In other words, the phase noise of the ring oscillator shown in FIG. 5 is -5 decibels less than the phase noise of the differential oscillator shown in FIG. 2. It can be seen from FIG. 8 that the phase noise of the ring oscillator shown in FIG. 5 is less than the phase noise of the differential oscillator shown in FIG. 2. In other words, compared with the differential oscillator shown in FIG. 2, the ring oscillator provided in embodiments of this application has lower phase noise and better performance.

In a possible embodiment, as shown in FIG. 9, the ring oscillator may further include a first switch Q1 and a second switch Q2. The first switch Q1 is coupled between the first input end 501 of the first differential inverting amplifier 50 and the first output end 502 of the first differential inverting amplifier 50, and the second switch Q2 is coupled between the second input end 503 of the first differential inverting amplifier 50 and the second output end 504 of the first differential inverting amplifier 50. The first switch Q1 and the second switch Q2 are switched, for example, the first switch Q1 and the second switch Q2 are simultaneously turned on or off, to control the ring oscillator to operate in a low phase noise mode or an anti-interference mode.

FIG. 9 is a diagram of a structure of a ring oscillator according to an embodiment of this application. The ring oscillator may include the first differential inverting amplifier 50, the second differential inverting amplifier 51, the third differential inverting amplifier 52, the first switch Q1, and the second switch Q2 that are coupled in a ring. The first input end 501 of the first differential inverting amplifier 50 is coupled to the first output end 502 of the first differential inverting amplifier 50 through the first switch Q1, and the second input end 503 of the first differential inverting amplifier 50 is coupled to the second output end 504 of the first differential inverting amplifier 50 through the second switch Q2. In an operating process of the ring oscillator, if the ring oscillator needs to operate in a low phase noise mode, the ring oscillator may be controlled to operate in the low phase noise mode by simultaneously turning on the first switch Q1 and the second switch Q2. In this case, a structure of the ring oscillator is the same as the structure of the ring oscillator shown in FIG. 5. If the ring oscillator needs to operate in an anti-interference mode, the ring oscillator may be controlled to operate in the anti-interference mode by simultaneously turning off the first switch Q1 and the second switch Q2. In this embodiment, the ring oscillator can be controlled to adapt to more operating modes by switching the first switch and the second switch, thereby improving utilization of the ring oscillator. In FIG. 9, an example in which a first polarity is positive and a second polarity is negative is used.

In a possible embodiment, the at least three differential inverting amplifiers may further include at least one fourth differential inverting amplifier 53, the at least one fourth differential inverting amplifier 53 is coupled between the second differential inverting amplifier 51 and the third differential inverting amplifier 52, a first input end 531 of the at least one fourth differential inverting amplifier 53 is coupled to a first output end 532 of the at least one fourth differential inverting amplifier 53, a second input end 533 of the at least one fourth differential inverting amplifier 53 is coupled to a second output end 534 of the at least one fourth differential inverting amplifier 53, a polarity of the first input end 531 of the at least one fourth differential inverting amplifier 53 and a polarity of the first output end 532 of the at least one fourth differential inverting amplifier 53 are the first polarity, a polarity of the second input end 533 of the at least one fourth differential inverting amplifier 53 and a polarity of the second output end 534 of the at least one fourth differential inverting amplifier 53 are the second polarity, and the first polarity is opposite to the second polarity.

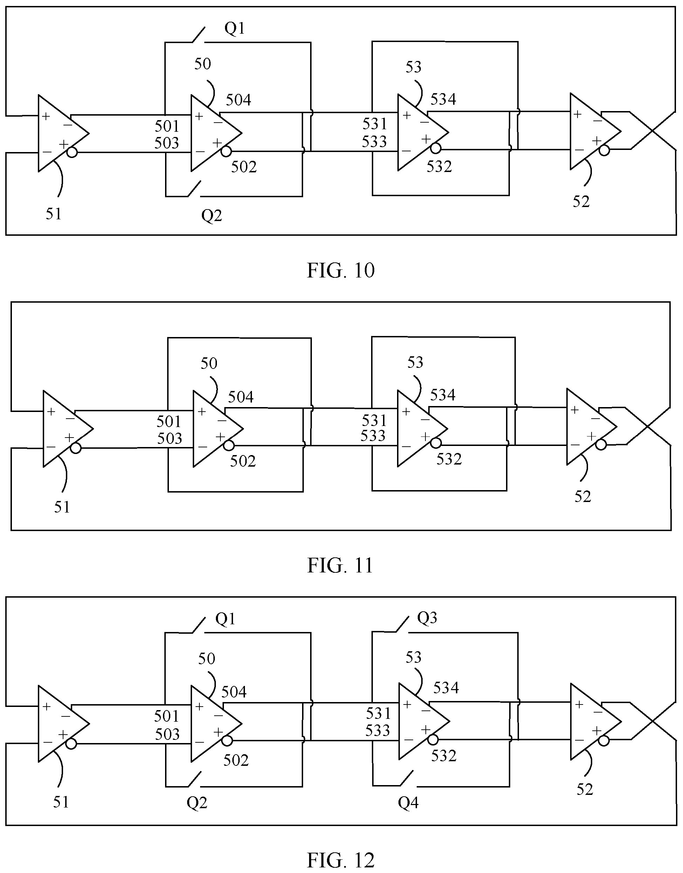

The at least one fourth differential inverting amplifier 53 may include one fourth differential inverting amplifier 53, or may include a plurality of fourth differential inverting amplifiers 53. For example, when the at least one fourth differential inverting amplifier 53 includes a plurality of fourth differential inverting amplifiers 53, the at least one fourth differential inverting amplifier 53 may include two, eight, or 10 fourth differential inverting amplifiers. This is not specifically limited in embodiments of this application. For ease of understanding, in FIG. 10 and the following embodiments, an example in which the at least one fourth differential inverting amplifier 53 includes one fourth differential inverting amplifier 53 is used.

In a possible embodiment, when the at least one fourth differential inverting amplifier 53 includes one fourth differential inverting amplifier 53, in a first possible implementation, the first polarity is positive, and the second polarity is negative, that is, the first input end 531 of the fourth differential inverting amplifier 53 and the first output end 532 of the fourth differential inverting amplifier 53 are positive electrodes, and the second input end 533 of the fourth differential inverting amplifier 53 and the second output end 534 of the fourth differential inverting amplifier 53 are negative electrodes. In a second possible implementation, the first polarity is negative, and the second polarity is positive, that is, the first input end 531 of the fourth differential inverting amplifier 53 and the first output end 532 of the fourth differential inverting amplifier 53 are positive electrodes, and the second input end 533 of the fourth differential inverting amplifier 53 and the second output end 534 of the fourth differential inverting amplifier 53 are negative electrodes.

The fourth differential inverting amplifier 53 is coupled between the second differential inverting amplifier 51 and the third differential inverting amplifier 52. For example, in a possible implementation, the fourth differential inverting amplifier 53 may be coupled between the second differential inverting amplifier 51 and the first differential inverting amplifier 50. In this case, a first output end and a second output end of the second differential inverting amplifier 51 are coupled to the first input end and the second input end of the fourth differential inverting amplifier 53, and the first output end and the second output end of the fourth differential inverting amplifier 53 are coupled to a first input end and a second input end of the first differential inverting amplifier 50. In another possible implementation, the fourth differential inverting amplifier 53 may be alternatively coupled between the first differential inverting amplifier 50 and the third differential inverting amplifier 52. In this case, a first output end and a second output end of the first differential inverting amplifier 50 are coupled to the first input end and the second input end of the fourth differential inverting amplifier 53, and the first output end and the second output end of the fourth differential inverting amplifier 53 are coupled to a first input end and a second input end of the third differential inverting amplifier 52. In the following embodiments, an example in which the fourth differential inverting amplifier 53 is coupled between the first differential inverting amplifier 50 and the third differential inverting amplifier 52 is used for description.

For example, FIG. 10 is a diagram of a structure of a ring oscillator according to an embodiment of this application. The ring oscillator may include a first differential inverting amplifier 50, a second differential inverting amplifier 51, a third differential inverting amplifier 52, a fourth differential inverting amplifier 53, a first switch Q1, and a second switch Q2 that are coupled in a ring. The third differential inverting amplifier 52 is in-phase coupled to the second differential inverting amplifier 51, and other adjacent differential inverting amplifiers are reversely coupled to each other, that is, a first output end (positive electrode) of the third differential inverting amplifier 52 is coupled to a first input end (positive electrode) of the second differential inverting amplifier 51, a second output end (negative electrode) of the third differential inverting amplifier 52 is coupled to an input end (negative electrode) of the second differential inverting amplifier 51, a first output end (positive electrode) of the second differential inverting amplifier 51 is coupled to a second input end 503 (negative electrode) of the first differential inverting amplifier 50, a second output end (negative electrode) of the second differential inverting amplifier 51 is coupled to a second input end 501 (positive electrode) of the first differential inverting amplifier 50, a first output end 502 (positive electrode) of the first differential inverting amplifier 50 is coupled to a second input end 533 (negative electrode) of the fourth differential inverting amplifier 53, a second output end 504 (negative electrode) of the first differential inverting amplifier 50 is coupled to a first input end 531 (positive electrode) of the fourth differential inverting amplifier 53, a first output end 532 (positive electrode) of the fourth differential inverting amplifier 53 is coupled to a first input end (negative electrode) of the third differential inverting amplifier 52, and a second output end 534 (negative electrode) of the fourth differential inverting amplifier 53 is coupled to a second input end (positive electrode) of the third differential inverting amplifier 52. The first input end 501 of the first differential inverting amplifier 50 is coupled to the first output end 502 of the first differential inverting amplifier 50 through the first switch Q1, and the second input end 503 of the first differential inverting amplifier 50 is coupled to the second output end 504 of the first differential inverting amplifier 50 through the second switch Q2. A polarity of the first input end 501 of the first differential inverting amplifier 50 and a polarity of the first output end 502 of the first differential inverting amplifier 50 are positive, a polarity of the second input end 503 of the first differential inverting amplifier 50 and a polarity of the second output end 504 of the first differential inverting amplifier 50 are negative, the first input end 531 of the fourth differential inverting amplifier 53 is coupled to the first output end 532 of the fourth differential inverting amplifier 53, and the second input end 533 of the fourth differential inverting amplifier 53 is coupled to the second output end 534 of the fourth differential inverting amplifier 53. A polarity of the first input end 531 of the fourth differential inverting amplifier 53 and a polarity of the first output end 532 of the fourth differential inverting amplifier 53 are positive, and a polarity of the second input end 533 of the fourth differential inverting amplifier 53 and a polarity of the second output end 534 of the fourth differential inverting amplifier 53 are negative. In FIG. 10, an example in which the first polarity is positive, the second polarity is negative, the third differential inverting amplifier 52 is in-phase coupled to the second differential inverting amplifier 51, and other differential inverting amplifiers are reversely coupled to each other is used.

In a possible implementation, when the ring oscillator needs to operate in the low phase noise mode, the first switch Q1 and the second switch Q2 are simultaneously turned on, so that the ring oscillator may operate in the low phase noise mode. In this case, a diagram of a structure of the ring oscillator is shown in FIG. 11.

In this embodiment, a quantity of differential inverting amplifiers coupled between the second differential inverting amplifier 51 and the third differential inverting amplifier 52 is increased, so that a tuning range of the ring oscillator can be increased, and application scenarios of the ring oscillator can be increased, thereby improving utilization of the ring oscillator.

In a possible embodiment, based on the ring oscillator shown in FIG. 10, an embodiment of this application provides a ring oscillator. FIG. 12 is a diagram of a structure of the ring oscillator. The ring oscillator further includes a third switch Q3 and a fourth switch Q4. The third switch Q3 is coupled between the first input end 531 of the fourth differential inverting amplifier 53 and the first output end 532 of the fourth differential inverting amplifier 53, and the fourth switch Q4 is coupled between the second input end 533 of the fourth differential inverting amplifier 53 and the second output end 534 of the fourth differential inverting amplifier 53.

In an operating process of the ring oscillator, the first switch Q1 and the second switch Q2 are turned off, and the third switch Q3 and the fourth switch Q4 are switched. For example, the third switch Q3 and the fourth switch Q4 are simultaneously turned on or off, to control the ring oscillator to separately operate in a low phase noise mode or an anti-interference mode. Alternatively, the third switch Q3 and the fourth switch Q4 are turned off, and the first switch Q1 and the second switch Q2 are switched. For example, the first switch Q1 and the second switch Q2 are simultaneously turned on or off, to control the ring oscillator to separately operate in the low phase noise mode or the anti-interference mode. Specifically, if the ring oscillator needs to operate in the low phase noise mode, the ring oscillator is controlled to operate in the low phase noise mode by turning off the first switch Q1 and the second switch Q2, and simultaneously turning on the third switch Q3 and the fourth switch Q4. Alternatively, the ring oscillator is controlled to operate in the low phase noise mode by turning off the third switch Q3 and the fourth switch Q4, and simultaneously turning on the first switch Q1 and the second switch Q2. If the ring oscillator needs to operate in the anti-interference mode, the first switch Q1, the second switch Q2, the third switch Q3, and the fourth switch Q4 are turned off, so that the ring oscillator operates in the anti-interference mode. In this embodiment, the ring oscillator can separately operate in the low phase noise mode or the anti-interference mode by selectively switching the first switch and the second switch, and the third switch and the fourth switch. This improves utilization and operability of the ring oscillator.

Embodiments of this application provide the ring oscillator. The ring oscillator includes the at least three differential inverting amplifiers that are coupled in a ring. Each differential inverting amplifier includes the first input end and the second input end that are differential, and the first output end and the second output end that are differential, and the first output end and the second output end of each differential inverting amplifier are respectively coupled to the first input end and the second input end of the next adjacent differential inverting amplifier. The at least three differential inverting amplifiers include the first differential inverting amplifier, the first input end of the first differential inverting amplifier is coupled to the first output end of the first differential inverting amplifier, and the second input end of the first differential inverting amplifier is coupled to the second output end of the first differential inverting amplifier. The polarity of the first input end and the polarity of the first output end are the first polarity, the polarity of the second input end and the polarity of the second output end are the second polarity, and the first polarity is opposite to the second polarity. In this way, when there is external noise interference, the noise interference is coupled to both the first input end and the second input end that are differential, and because polarities of the first input end and the second input end are opposite, the external noise interference can be completely offset, that is, anti-interference performance of the ring oscillator is improved according to a differential principle. In addition, the polarity of the first input end is the same as the polarity of the first output end, and the polarity of the second input end is the same as the polarity of the second output end, that is, an input end and an output end that are of the first differential inverting amplifier and that have a same polarity are coupled to each other. In other words, the first differential inverting amplifier is coupled from the head to the tail, so that a conversion rate and symmetry of a differential oscillation waveform of the ring oscillator are improved, and a mean square value of an impulse-sensitive function is reduced, thereby reducing phase noise.

An embodiment of this application further provides a phase locked loop circuit. The phase locked loop circuit may include a phase detector, a filter, and a ring oscillator, and the ring oscillator may be the ring oscillator provided in FIG. 5, FIG. 6, FIG. 9, FIG. 10, FIG. 11, or FIG. 12.

An embodiment of this application further provides a communication apparatus. The communication apparatus may include a phase locked loop circuit, the phase locked loop circuit may include a ring oscillator, and the ring oscillator may be the ring oscillator provided in FIG. 5, FIG. 6, FIG. 9, FIG. 10, FIG. 11, or FIG. 12.

In a possible embodiment, the communication apparatus may include a radio frequency transceiver, the phase locked loop circuit is integrated into the radio frequency transceiver, and the phase locked loop circuit is configured to provide a local carrier signal for the radio frequency transceiver. It should be noted that, for related descriptions of the ring oscillator, refer to related descriptions of the ring oscillator provided above. Details are not described herein again in this embodiment of this application.

In conclusion, the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A ring oscillator, wherein the ring oscillator comprises at least three differential inverting amplifiers that are coupled in a ring, each differential inverting amplifier comprises a first input end and a second input end that are differential, and a first output end and a second output end that are differential, and the first output end and the second output end of each differential inverting amplifier are respectively coupled to a first input end and a second input end of a next adjacent differential inverting amplifier; and
the at least three differential inverting amplifiers comprise a first differential inverting amplifier, a first input end of the first differential inverting amplifier is coupled to a first output end of the first differential inverting amplifier, a second input end of the first differential inverting amplifier is coupled to a second output end of the first differential inverting amplifier, a polarity of the first input end and a polarity of the first output end are a first polarity, a polarity of the second input end and a polarity of the second output end are a second polarity, and the first polarity is opposite to the second polarity.

2. The ring oscillator according to claim 1, wherein the at least three differential inverting amplifiers further comprise a second differential inverting amplifier and a third differential inverting amplifier, and the first differential inverting amplifier is coupled between the second differential inverting amplifier and the third differential inverting amplifier.

3. The ring oscillator according to claim 1 or 2, wherein the ring oscillator further comprises a first switch and a second switch; and
the first switch is coupled between the first input end of the first differential inverting amplifier and the first output end of the first differential inverting amplifier, and the second switch is coupled between the second input end of the first differential inverting amplifier and the second output end of the first differential inverting amplifier.

4. The ring oscillator according to claim 3, wherein the ring oscillator is controlled to operate in a low phase noise mode or an anti-interference mode by switching the first switch and the second switch.

5. The ring oscillator according to any one of claims 1 to 4, wherein the at least three differential inverting amplifiers further comprise at least one fourth differential inverting amplifier, the at least one fourth differential inverting amplifier is coupled between the second differential inverting amplifier and the third differential inverting amplifier, a first input end of the at least one fourth differential inverting amplifier is coupled to a first output end of the at least one fourth differential inverting amplifier, a second input end of the at least one fourth differential inverting amplifier is coupled to a second output end of the at least one fourth differential inverting amplifier, a polarity of the first input end of the at least one fourth differential inverting amplifier and a polarity of the first output end of the at least one fourth differential inverting amplifier are the first polarity, and a polarity of the second input end of the at least one fourth differential inverting amplifier and a polarity of the second output end of the at least one fourth differential inverting amplifier are the second polarity.

6. The ring oscillator according to claim 5, wherein the ring oscillator further comprises a third switch and a fourth switch; and
the third switch is coupled between the first input end of the at least one fourth differential inverting amplifier and the first output end of the at least one fourth differential inverting amplifier, and the fourth switch is coupled between the second input end of the at least one fourth differential inverting amplifier and the second output end of the at least one fourth differential inverting amplifier.

7. The ring oscillator according to claim 6, wherein the ring oscillator is controlled to operate in the low phase noise mode or the anti-interference mode by turning off the first switch and the second switch and switching the third switch and the fourth switch; or
the ring oscillator is controlled to operate in the low phase noise mode or the anti-interference mode by turning off the third switch and the fourth switch and switching the first switch and the second switch.

8. The ring oscillator according to any one of claims 1 to 7, wherein only one differential inverting amplifier in the at least three differential inverting amplifiers is reversely coupled to an adjacent differential inverting amplifier, and all other differential inverting amplifiers other than the differential inverting amplifier in the at least three differential inverting amplifiers are in-phase coupled to adjacent differential inverting amplifiers.

9. The ring oscillator according to any one of claims 1 to 7, wherein only one differential inverting amplifier in the at least three differential inverting amplifiers is in-phase coupled to an adjacent differential inverting amplifier, and all other differential inverting amplifiers other than the differential inverting amplifier in the at least three differential inverting amplifiers are reversely coupled to adjacent differential inverting amplifiers.

10. A phase locked loop circuit, wherein the phase locked loop circuit comprises a phase detector, a filter, and a ring oscillator, the ring oscillator is the ring oscillator according to any one of claims 1 to 9, the phase detector is configured to: obtain a phase difference signal, and convert the phase difference signal into a voltage signal, the filter is configured to filter the voltage signal, and the ring oscillator is configured to output a local carrier signal based on the filtered voltage signal.

11. A communication apparatus, wherein the communication apparatus comprises a phase locked loop circuit, and the phase locked loop circuit comprises the ring oscillator according to any one of claims 1 to 9.

12. The communication apparatus according to claim 11, wherein the communication apparatus further comprises a radio frequency transceiver, the phase locked loop circuit is integrated into the radio frequency transceiver, and the phase locked loop circuit is configured to provide a local carrier signal for the radio frequency transceiver.
